# EUROPEAN PATENT APPLICATION

(11) **EP 4 822 742 A1**
(43) Date of publication of application: **14.10.2026**
(21) Application number: 25169366.9
(22) Date of filing: 09.04.2025
(51) Int. Cl.: H01L 23/31, H01L 23/495, H01L 23/48, H01L 23/538, H01L 23/373, H01L 23/36

(54) **SEMICONDUCTOR PACKAGE INCLUDING A PRE-PACKAGE AND PRE-PACKAGE**

(71) Applicant: Infineon Technologies Austria AG, 9500 Villach (AT)
(72) Inventor: WÖTZEL, Stefan, 99084 Erfurt (DE); NG, Chee Yang, 84000 Muar, Jalan Ismail (MY); BÖHM, Marcus, 93098 Mintraching (DE)
(74) Representative: Lambsdorff & Lange Patentanwälte Partnerschaft mbB

(57) **Abstract**

A semiconductor package includes a pre-package, a pre-package carrier on which the pre-package is mounted and an encapsulant embedding the pre-package and the pre-package carrier. The pre-package includes a power transistor chip having a first side and a second side opposite the first side. The power transistor chip is a lateral semiconductor device. A plurality of source load pads and a plurality of drain load pads are arranged at the first side of the power transistor chip. A pre-package body embeds the power transistor chip at least at its first side, the pre-package body comprising a first side facing away from the first side of the power transistor chip. A structured metal layer is disposed over the first side of the pre-package body. The structured metal layer comprises one continuous source load structure and one continuous drain load structure. A pre-package vertical interconnect runs through material of the pre-package body and is configured to connect at least some of the source load pads to the source load structure and at least some of the drain load pads to the drain load structure. The pre-package is mounted on the pre-package carrier with the structured metal layer facing the pre-package carrier.

## Description

### Technical Field

This disclosure relates generally to the technique of semiconductor packaging, and in particular to packaging of a power transistor chip being a lateral semiconductor device.

### Background

Packaging techniques can have a high impact on device performance. Packaging concepts may aim to provide a high routing capability, a high variability of footprint design, a good board level reliability (e.g., high Thermal Cycling on Board (TCoB) performance) and good thermal dissipation into the board as well as low assembly cost. Moreover, in particular for power applications, the packaging concept should provide for low inductance and low resistance of the package-internal interconnect, because otherwise, the customer may not be able to enjoy the low R_{DS(on)} of the power transistor chip, for example.

In addition, packaging concepts that do not require the customer to significantly change the layout of the application board are more compatible with the market. Therefore, semiconductor packages with a footprint and/or terminal layout that is identical or close to standardized package solutions can be advantageous.

### Summary

According to an aspect of the disclosure, a semiconductor package includes a pre-package, a pre-package carrier on which the pre-package is mounted and an encapsulant embedding the pre-package and the pre-package carrier. The pre-package includes a power transistor chip having a first side and a second side opposite the first side. The power transistor chip is a lateral semiconductor device. A plurality of source load pads and a plurality of drain load pads are arranged at the first side of the power transistor chip. A pre-package body embeds the power transistor chip at least at its first side, the pre-package body comprising a first side facing away from the first side of the power transistor chip. A structured metal layer is disposed over the first side of the pre-package body. The structured metal layer comprises one continuous source load structure and one continuous drain load structure. A pre-package vertical interconnect runs through material of the pre-package body and is configured to connect at least some of the source load pads to the source load structure and at least some of the drain load pads to the drain load structure. The pre-package is mounted on the pre-package carrier with the structured metal layer facing the pre-package carrier.

According to another aspect of the disclosure, a pre-package includes a power transistor chip having a first side and a second side opposite the first side. The power transistor chip is a lateral semiconductor device. A plurality of source load pads and a plurality of drain load pads are arranged at the first side of the power transistor chip. A pre-package body embeds the power transistor chip at least at its first side, the pre-package body comprising a first side facing away from the first side of the power transistor chip. A structured metal layer is disposed over the first side of the pre-package body. The structured metal layer comprises one continuous source load structure and one continuous drain load structure. A pre-package vertical interconnect runs through material of the pre-package body and is configured to connect at least some of the source load pads to the source load structure and at least some of the drain load pads to the drain load structure.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a schematic sectional view of an example of a semiconductor package including an example of a pre-package.
Figure 2 is a schematic sectional view of an example of a semiconductor package including another example of a pre-package.
Figure 3 is a schematic sectional view of a further example of a semiconductor package including, by way of example, the pre-package of Figure 2.
Figure 4 is a plan view on a first side of an example of a power transistor chip illustrating an exemplary layout of source, drain and gate pads.
Figure 5A is a plan view on an example of a structured metal layer disposed over the first side of a power transistor chip
Figure 5B is a schematic sectional view along line A-A of Figure 5A.
Figure 5C is a schematic sectional view along line B-B of Figure 5A.
Figure 6A is a plan view on another example of a structured metal layer disposed over the first side of a power transistor chip.
Figure 6B is a plan view on the first side of the power transistor chip of Figure 4, showing which load pads are connected to the structured metal layer designed in accordance with Figure 6A.
Figure 7 is a perspective top view on a TOLL package embedding a pre-package as disclosed herein, wherein the encapsulant of the TOLL package is shown transparent.
Figure 8 is a schematic sectional view of an example of a pre-package as used in the semiconductor package of Figure 1.
Figure 9 is a schematic sectional view of another example of a pre-package as used in the semiconductor packages of Figures 2 and 3.
Figure 10A is a perspective top view on a power transistor chip.
Figure 10B is a perspective top view on an example of a pre-package embedding the power transistor chip of Figure 10A, wherein the pre-package body is shown transparent.
Figure 10C is a perspective top view on the example of a pre-package of Figure 10B, wherein the structured metal layer and the pre-package body are shown transparent.
Figure 10D is a perspective bottom view on the example of a pre-package of Figure 10B.
Figure 11A is a perspective top view on a SSO8 package embedding a pre-package as disclosed herein, wherein the encapsulant of the SSO8 package is shown transparent.
Figure 11B is a perspective top view on the SSO8 package of Figure 11A.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

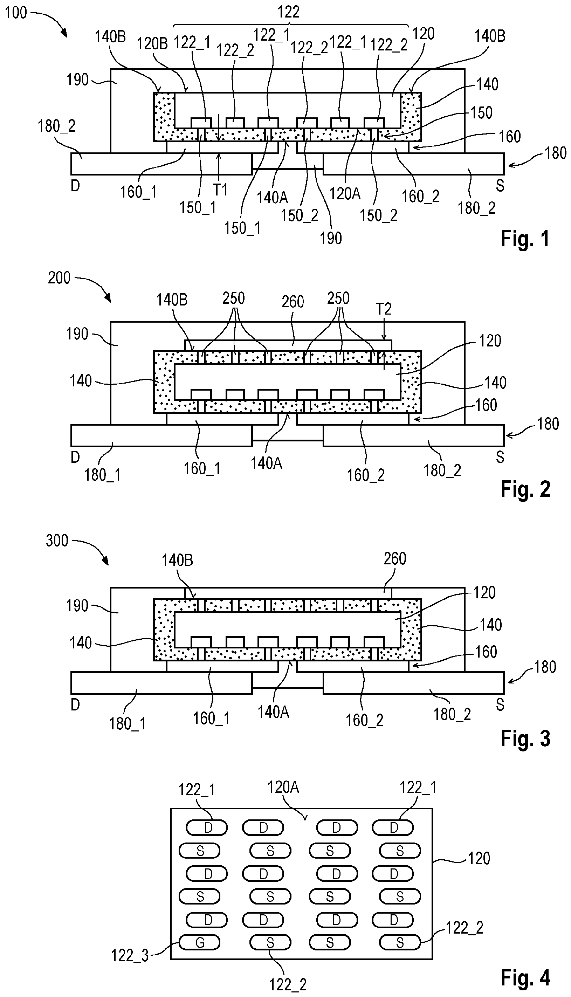

Referring to Figure 1, a semiconductor package 100 includes a power transistor chip 120. The power transistor chip 120 has a first side 120A and a second side 120B opposite the first side 120A.

A plurality of load pads 122 are arranged at the first side 120A of the power transistor chip 120. The plurality of load pads 122 includes a plurality of drain load pads 122_1 and a plurality of source load pads 122_2. Further, a gate load pad 122_3 (see Figure 4) may be arranged at the first side 120A of the power transistor chip 120.

The power transistor chip 120 is a lateral semiconductor device. In lateral semiconductor devices, the load current is flowing mainly in a lateral direction between load pads 122. In a lateral semiconductor device, the power transistor chip 120 may have load pads 122 only on the first side 120A of the power transistor chip 120.

The power transistor chip 120 is embedded in a pre-package body 140 at least at its first side 120A. The pre-package body 140 includes a first side 140A facing away from the first side 120A of the power transistor chip 120. A second side 140B of the pre-package body 140, opposite the first side 140A, may, e.g., extend beyond the first side 120A of the power transistor chip 120 so that the pre-package body 140 may cover partially or fully the side walls of the power transistor chip 120.

In some examples, the pre-package body 140 is a laminated body. Differently put, the pre-package is a laminate package. In laminate packages, the power transistor chip 120 is embedded in laminate according to well-known lamination techniques.

In other examples, the pre-package body 140 may, e.g., be a mold compound body. In other words, the pre-package is a molded package in which the power transistor chip 120 is embedded in the package by a molding process.

It is to be noted that the pre-package body 140, if made of a mold compound, may not be formed of a laser-activatable mold compound, for example. Such known laser-activatable mold compounds are doped with a laser-activatable additive which, however, raises the cost of the mold compound.

A structured metal layer 160 is disposed over the first side 140A of the pre-package body 140. The structured metal layer 160 comprises one continuous drain load structure 160_1 and one continuous source load structure 160_2. The continuous drain load structure 160_1 and the continuous source load structure 160_2 are insular, i.e. separated from each other.

The plurality of drain load pads 122_1 and the plurality of source load pads 122_2 are connected to the drain load structure 160_1 and the source load structure 160_2, respectively, by a pre-package vertical interconnect, referred to in the following as vertical interconnect 150. The vertical interconnect 150 is running through material of the pre-package body 140. The vertical interconnect 150 is configured to connect at least some of the drain load pads 122_1 to the drain load structure 160_1 and at least some of the source load pads 122_2 to the source load structure 160_2.

In other words, the drain load structure 160_1 collects the drain load current of the power transistor chip 120 flowing through at least some of the drain load pads 122_1, and the source load structure 160_2 collects the source load current of the power transistor chip 120 flowing through at least some of the source load pads 122_2.

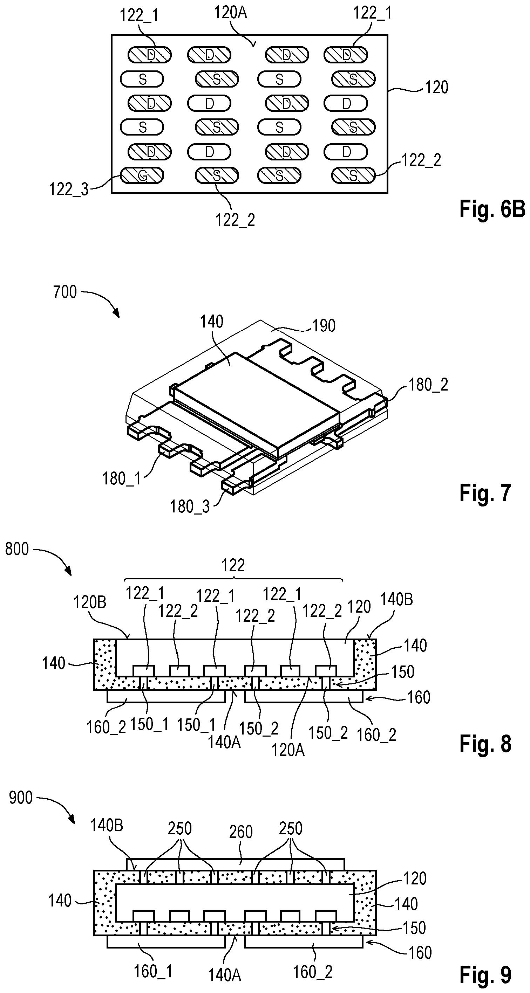

The power transistor chip 120, the load pads 122, the pre-package body 140, the vertical interconnect 150 and the structured metal layer 160 form (an example of) a pre-package, see e.g. Figure 8 showing a pre-package 800 which is used in the semiconductor package 100.

The semiconductor package 100 further includes a pre-package carrier 180. The pre-package (e.g., the pre-package 800 of Figure 8 or any other pre-package) is mounted on the pre-package carrier 180 with the structured metal layer 160 facing the pre-package carrier 180.

The pre-package carrier 180 may comprise a drain terminal 180_1 and a source terminal 180_2. The drain terminal 180_1 is bonded to the drain load structure 160_1 and the source terminal 180_2 is bonded to the source load structure 160_2. For example, the bond material may comprise or be of solder, conductive adhesive, metal sinter paste, or diffusion solder material.

The drain terminal 180_1 and the source terminal 180_2 may form package terminals configured for mounting the semiconductor package 100 on an application board (not shown).

In general, the pre-package carrier 180 may, e.g., be of various types. The pre-package carrier 180 may, e.g., be a leadframe. In this case, the drain terminal 180_1 and the source terminal 180_2 may, e.g., be leads. In other examples, the pre-package carrier 180 may, e.g., be a PCB (Printed Circuit Board) or a ceramic-based carrier such as, e.g., a DCB (Direct Copper Bonding) carrier.

An encapsulant 190 embeds the pre-package and the pre-package carrier 180. The encapsulant 190 may be formed by a package mold compound. The package mold compound may be different from a mold compound of the pre-package body 140 (if the pre-package body is also formed of a mold compound). In this case, two separate molding processes need to be carried out for forming the pre-package body 140 and the encapsulant 190.

In many cases the pre-package body 140 is a laminate and the encapsulant 190 is a mold compound. Thus, in general, different packaging techniques may be used for generating the pre-package body 140 of the pre-package and the encapsulant 190 of the semiconductor package 100 embedding the pre-package.

The power transistor chip 120 can be of different types. Examples described herein are, in particular, directed to HEMT (High Electron Mobility Transistor) devices. The power transistor chip 120 may, e.g., be a III-V compound power transistor chip having, e.g., a high band gap. The transistor chip 120 may, e.g., be a GaN chip. In this case, the GaN chip 120 may, e.g., be a lateral GaN-on-substrate device such as a GaN-on-Si device or a GaN-on-SiC device or a GaN-on-sapphire device, for example.

As will be described in more detail further below, a thickness T1 of the structured metal layer 160 may, e.g., be substantially greater than a thickness of chip-internal metallization layers. For example, the thickness T1 may be between 25 µm und 105 µm, or 35 µm and 70 µm. On the other hand, the metal thickness of chip-internal metallization layers, e.g. BEoL (BackEnd of Line) Metal 1 and/or Metal 2 layers, may be limited to a thickness of less than 5 µm. Therefore, the structured metal layer 160 is a low-ohmic layer compared to a BEoL metallization layer.

The vertical interconnect 150 may be formed of a plurality of vertical drain interconnect structures 150_1 running through material of the pre-package body 140. The vertical drain interconnect structures 150_1 are configured to connect at least some of the drain load pads 122_1 to the drain load structure 160_1.

The pre-package vertical interconnect 150 may further comprise a plurality of vertical source interconnect structures 150_2 running through the material of the pre-packaged body 140. The vertical source interconnect structures 150_2 are configured to connect at least some of the source load pads 122_2 to the source load structure 160_2.

Each vertical interconnect structure 150_1, 150_2 may be formed as a via. The vias may be produced by generating holes in the first side 140A of the pre-package body 140 and filling the holes by an electrically conductive material. For example, the holes may be produced by lithography and etching processes. The holes may be filled by metal plating, e.g., during depositing the metal of the structured metal layer 160. The structured metal layer 160 may be formed by metal plating, e.g. by galvanic plating or electroless plating.

Figure 2 shows a semiconductor package 200 which is designed largely in accordance with semiconductor package 100, and reference is made to the above description to avoid reiteration. The semiconductor package 200 distinguishes from the semiconductor package 100 in that a metal layer 260 is disposed over the second side 120B of the power transistor chip 120.

For example, the second side 120B of the power transistor chip 120 may be embedded in the pre-package body 140. In other words, the second side 140B of the pre-package body 140 may cover the second side 120B of the power transistor chip 120.

The metal layer 260 may, e.g., be connected to the second side 120B of the power transistor chip 120 by a vertical interconnect 250. The vertical interconnect 250 may be formed the same way as described with regard to the vertical interconnect 150, and reference is made to the above description to avoid reiteration. In particular, the vertical interconnect 250 may run through material of the pre-package body 140. The vertical interconnect 250 may be formed by an array of vias which may, e.g., be filled with metal during a plating process used for forming the metal layer 260.

The metal layer 260 may, e.g., have a thickness T2 within the ranges given for the thickness T1 of the structured metal layer 160. The metal layer 260 may be used for heat spreading and/or heat removal. In addition, the metal layer 260 may be used for providing a defined electrical potential at the backside of the power transistor chip 120. For example, the metal layer 260 may be held on ground or source potential. Such defined potential at the backside of the power transistor chip 120 may improve the performance of the power transistor chip 120.

Figure 3 illustrates a semiconductor package 300. The pre-package used in semiconductor package 300 is identical with the pre-package used in semiconductor package 200, see e.g. Figure 9 showing a pre-package 900 which is used in the semiconductor packages 200 and 300. However, in semiconductor package 300, the metal layer 260 remains exposed at the top side of the encapsulant 190. This allows to couple the metal layer 260 to a heat sink to improve thermal dissipation (i.e. provides a Top Side Cooling (TSC) package).

Figure 4 shows an exemplary layout of chip pads 122_1, 122_2, 122_3 on the first side 120A of an exemplary power transistor chip 120. The layout of chip pads 122_1, 122_2, 122_3 may include a plurality of drain pads (D) 122_1 and a plurality of source pads (S) 122_2. Further, a gate pad (G) 122_3 may be provided.

The plurality of source pads (S) 122_2 and the plurality of drain pads (D) 122_1 may be arranged in an interdigitated load pad array. For example, the plurality of source pads (S) 122_2 may be, e.g., arranged in a number of (horizontal) rows parallel to the longitudinal side of the power transistor chip 120. Likewise, the plurality of drain pads (D) 122_1 may be arranged in a number of (horizontal) rows parallel to the rows of the source pads (S) 122_2.

In the example shown in Figure 2, the rows of drain pads (D) 122_1 and the rows of source pads (S) 122_2 are, e.g., interleaved and/or alternating. In other examples, a plurality (e.g., 2) of the rows of drain pads (D) 122_1 and a plurality (e.g., 2) of the rows of source pads (S) 122_2 may, e.g., be interleaved and/or alternating.

Further, the drain pads (D) 122_1 and the source pads (S) 122_2 may, e.g., be offset from each other in the longitudinal (horizontal) direction. In other examples, the drain pads (D) 122_1 and the source pads (S) 122_2 may, e.g., be aligned to each other in the longitudinal (horizontal) direction. The gate pad (G) 122_3 may be arranged at a corner of the power transistor chip 120 and may, e.g., be formed by a single gate pad (G).

In general, the number of drain pads (D) 122_1 and/or the number of source pads (S) 122_2 of the power transistor chip 120 may each be equal to or greater than 6, 8, 10, 12 or even higher. The plurality of drain pads (D) 122_1 and the plurality of source pads (S) 122_2 may be distributed over a major portion (e.g. equal to or greater than 70% or 80% or 90%) of the area of first side 120A of the power transistor chip 120. In particular, the plurality of drain pads (D) 122_1 and the plurality of source pads (S) 122_2 may be distributed over the entire active area of the power transistor chip 120.

Such a distributed load pad layout allows to achieve short mean path lengths for electrons to travel through the BEoL metal to reach a load pad and is therefore optimized for electrical performance (by means of reduced power transistor chip R_{DS(on)}).

More specifically, medium voltage (MV) GaN chip technology contains, e.g., two metallization layers which collect the different potentials on epitaxial level and merges them in the plurality of drain pads (D) 122_1 and the plurality of source pads (S) 122_2 by using metal runners located over the entire active chip area. These extended metal lines of restricted trace thickness offer only limited redistribution of current/power loads on chip level. Therefore, for the current MV GaN chip types, the pads for source and drain (i.e., the plurality of drain pads (D) 122_1 and the plurality of source pads (S) 122_2) are arranged in an interdigitated pattern. While the mean path length for electrons to travel through the BEoL metal to reach a die pad 122 is optimized for electrical performance (by means of reduced R_{DS(on)}), this pad layout complicates the integration of GaN HEMTs in standard packages.

The freedom-in-design to rearrange the drain load pads 122_1 and source load pads 122_2 is limited due to chip performance reason. Since the current is conducted laterally over the chip and the metal thickness in the chip's BEoL is limited (currently < 5 µm AlCu), long distance routing needs to be avoided to maintain low R_{DS(on)} characteristics within the device.

The (exemplary) layout of chip pads S, D, G of Figure 4 (or any other layout formed of an array of load pads distributed over a major portion of the first side 120A of the power transistor chip 120) is re-routed by a package-internal interconnect in order to provide single source and single drain package terminals such as, e.g., drain terminal 180_1 and source terminal 180_2, respectively. Re-routing for merging the plurality of drain pads (D) 122_1 and the plurality of source pads (S) 122_2 is performed by the vertical interconnect 150 and the structured metal layer 160, i.e. by features of the pre-package rather than by chip-internal BEoL metallization.

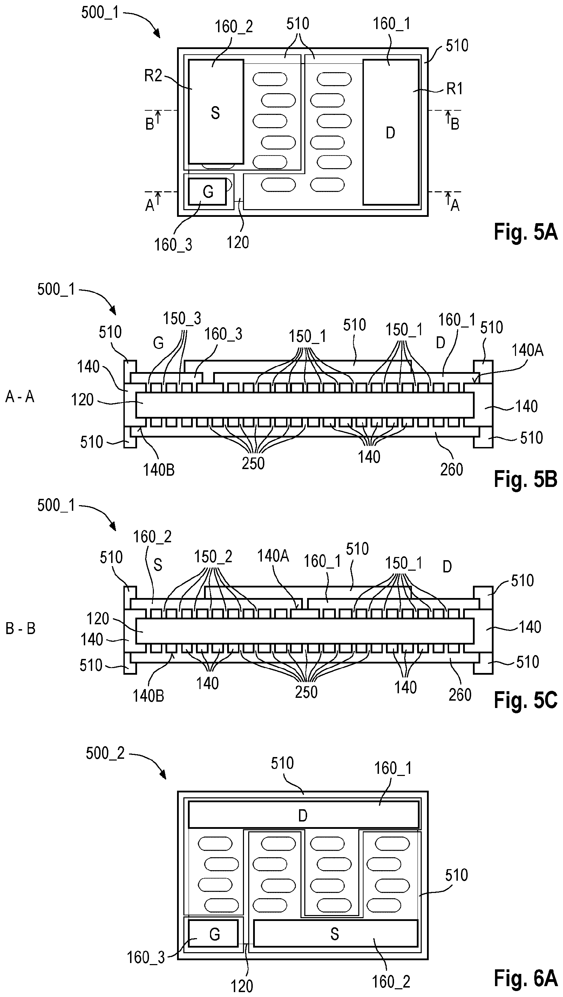

Figure 5A is a plan view on a pre-package 500_1 showing an example of a structured metal layer 160. Sectional views along line A-A and line B-B are shown in Figures 5B and 5C, respectively.

The structured metal layer 160 is disposed over a power transistor chip 120 having a load pad layout as shown in Figure 4, for example. As mentioned before, the single continuous drain load structure 160_1 merges the drain load pads 122_1 and the single continuous source load structure 160_2 (which is separated from the drain load structure 160_1) merges the source load pads 122_2. The structured metal layer 160 may further include a gate structure 160_3, which is connected to the gate pad 122_3.

For example, the connection between the gate pad 122_3 and the gate structure 160_3 may be provided by a plurality of vertical gate interconnect structures 150_3, see Figure 5B. The vertical gate interconnect structures 150_3 may be fabricated the same way as the vertical drain and/or source interconnect structures 150_1, 150_2, respectively.

The drain load structure 160_1 and the source load structure 160_2 may cover a major portion (e.g. equal to or greater than 60% or 70% or 80% or 90%) of the area of the first side 140A of the pre-package body 140. Similarly, the metal layer 260, if present, may cover a major portion (e.g. equal to or greater than 60% or 70% or 80% or 90%) of the area of the second side 140B of the pre-package body 140.

The pre-package 500_1 may further include an insulating cover layer 510. The insulating cover layer 510 is shown in Figure 5A in a semi-transparent manner. The insulating cover layer 510 may partially cover the drain load structure 160_1, the source load structure 160_2 and/or the gate structure 160_3 to expose these structures 160_1, 160_2, 160_3 at uncovered portions thereof. The insulating cover layer 510 may, e.g., be a solder stop layer.

As shown in Figure 5A, the insulating cover layer 510 may, e.g., define a stripe-shaped uncovered region R1 of the drain load structure 160_1 and/or may define a stripe-shaped uncovered region R2 of the source load structure 160_2, for example. These stripe-shaped regions R1, R2 may be designed in alignment with the desired terminal layout (footprint) of the semiconductor package 100, 200, 300 in which the pre-package 500_1 is intended to be integrated.

As illustrated by way of example in Figure 5A, the stripe-shaped regions R1, R2 may, e.g., be oriented perpendicular to the longitudinal extension of the power transistor chip 120.

Figure 6A illustrates another design option for structuring the structured metal layer 160 of a pre-package 500_2. Here, the drain load structure 160_1 and the source load structure 160_2 may be formed in a comb-like fashion having interdigitated fingers.

Again, stripe-shaped regions R1, R2 are left uncovered by the insulating cover layer 510. The stripe-shaped regions R1, R2 are, for example, oriented parallel to the longitudinal extension of the power transistor chip 120.

The design of the structured metal layer 160 may, e.g., be chosen dependent on the terminal layout of the semiconductor package 100, 200, 300 in which the pre-package 500_1, 500_2 is intended to be integrated and/or may also be chosen dependent on the geometry (layout) of the load pad array of the power transistor chip 120. For example, given the load pad array layout of Figure 4, Figure 6B highlights by hatching which drain load pads 122_1 and source load pads 122_2 (and also the gate pad 122_3) are connected to the structured metal layer 160.

Generally, it is not necessary that each drain load pad 122_1 and/or each source load pad 122_2 is connected to the structured metal layer 160 by the vertical interconnect 150. For example, as shown in Figure 6B, 4 drain load pads out of 12 drain load pads 122_1 and 4 source load pads out of 12 source load pads 122_2 are not connected to the structured metal layer 160. As these drain and source load pads 122_1, 122_2 are interconnected by chip-internal metallization (e.g. runners), the function of the power transistor chip 120 is not affected by some disconnected load pads. However, the better the area coverage of the connected load pads 122_1, 122_2, the better is the performance in terms of a low R_{DS(on)} of the semiconductor package 100, 200.

Differently stated, the basic concept to overcome the limitations of the distributed chip pad layout is the application of an embedded-chip approach for, e.g., MV GaN devices as pre-package. Here, the thick metal layer 160 (e.g., T1 is 35 µm) on the bottom of the embedded-chip arrangement can be used for further routing and merging source and drain potential. The original pad layout (see Figure 4, for example) of the power transistor chip 120 can be preserved.

The pre-package may be integrated in standard packages such as, e.g., a standard Joint Electron Device Engineering Counsel (JEDEC) package. Figure 7 illustrates a TOLL (TO-LeadLess) package 700. The TOLL package 700 has a JEDEC registration number MO-299B. Its dimensions are 10 × 11 × 2.3 mm. It is optimized for high current applications.

Figure 7 also illustrates by way of example that the pre-package carrier 180 may include a gate terminal 180_3 of the package 700. The gate terminal 180_3 is bonded to the gate structure 160_3 of the pre-package.

Other standard packages in which a pre-package in accordance with the disclosure can be integrated are, e.g., the TOLG (TO-Leaded with Gullwing geometry) and the TOLT (TO-Leaded Top-side cooling) packages.

The TOLG package has the JEDEC registration number MO-327A. Its dimensions are 10 × 11 × 2.3 mm. This package is optimized for high TCoB performance.

TOLT packages are registered with JEDEC by registration number MO-332A. Its dimensions are 9.9 × 15 × 2.3 mm. This package is optimized for superior thermal performance.

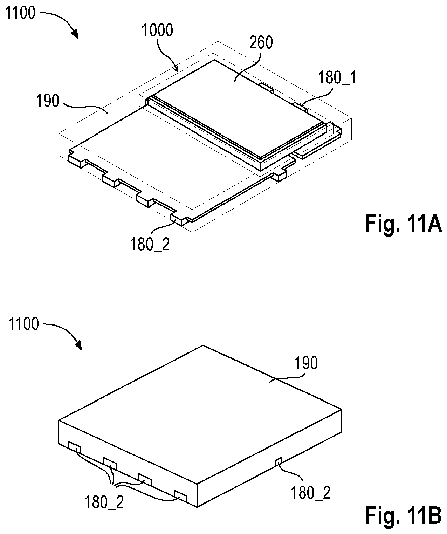

Further, a pre-package in accordance with the disclosure can be integrated in a SSO8 package, see Figures 11A and 11B. A SSO8 package has dimensions of 6.44 × 5.15 × 1.0 mm.

It is to be noted that all these standard packages are designed and optimized for vertical device technology. As such, these standard packages rely on strong customer acceptance in terms of reliability and TCoB performance, however, cannot deliver the full technology potential of a lateral power transistor chip (e.g., an MV GaN) on package level. In one aspect, the pre-package concept disclosed herein can be seen as a way of adapting lateral transistor chips for integration into standard packages designed for vertical devices.

The concept of integrating a pre-package designed in accordance with the disclosure into a standard package avoids to change the load pad layout of the power transistor chip 120 by using the BEoL metallization for additional routing. Calculations show that merging the drain and source currents on the BEoL metallization (i.e. on chip level) would increase R_{DS(on)} from about 0.14 mΩ to 1.7 mΩ in the final metallization layer. This can be avoided by using the structured metal layer 160 of the pre-package as the final redistribution layer.

In addition, except TOLx packages with x = T, L or G, or SSO8 packages, there are still other standard package types in which a pre-package in accordance of the disclosure can be integrated. For example, the pre-package may be integrated in a standard BGA (Ball Grid Array) package or a QFN (Quad Flat No-lead) package or a LGA (Land Grid Array) package.

Further, a pre-package in accordance with the disclosure is independently marketable, i.e. it does not need to be integrated in a package but can be sold as such. Even at the customer's site, the pre-package does not need to be integrated in a (standard) semiconductor package. Rather, it is also possible to use a pre-package similarly as a bare die or a bare die package, i.e. to mount it directly on an application board e.g., a PCB.

Pre-packages are shown by way of example in Figures 8 and 9. Pre-package 800 is the pre-package used in the semiconductor package 100 of Figure 1. Pre-package 900 is the pre-package used in the semiconductor packages 200 and 300 of Figures 2 and 3, respectively. In these examples and also in general, the structured metal layer 160 may be the sole off-chip metal layer of the pre-package 800, 900 in a direction facing away from the first side 120A of the power transistor chip 120. Reference is made to the description before in order to avoid reiteration.

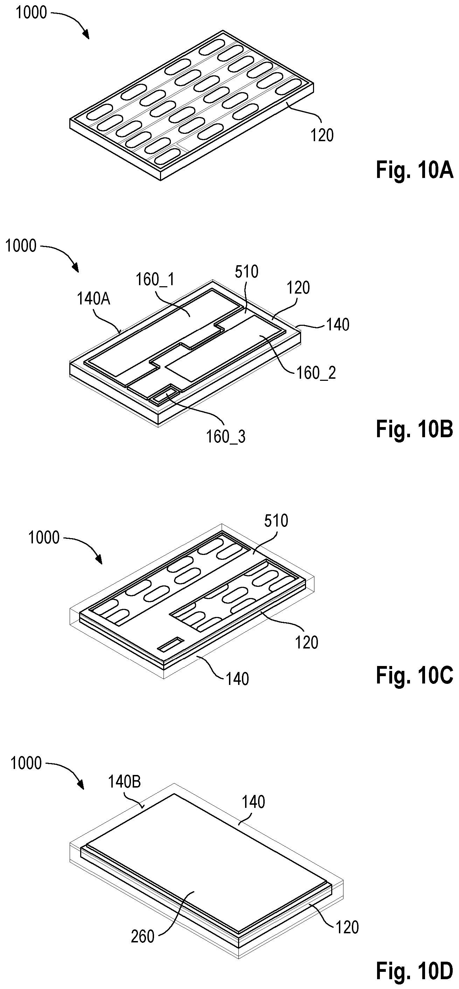

Figure 10A is a perspective top view on a power transistor chip 120. The power transistor chip 120 has a load pad layout as shown in Figure 4. That is, the plurality of source load pads and the plurality of drain load pads are arranged in an interdigitated load pad array.

Figure 10B illustrates a pre-package 1000. The pre-package 100 or "inlay" is designed largely in accordance with the pre-package 500_2 shown in Figure 6A. The structured metal layer 160 is partitioned in a drain load structure 160_1, a source load structure 160_2 and a gate structure 160_3. The drain load structure 160_1 and the source load structure 160_2 run along the longitudinal sides of the power transistor chip 120. The pre-package body (laminate) 140 is shown transparent and the insulating cover layer 510 is shown semi-transparent.

Figure 10C illustrates the same pre-package 1000 as Figure 10B, however with the structured metal layer 160 rather than the insulating cover layer 510 is shown transparent.

Figure 10D illustrates the metal layer 260 arranged on the second side 140B of the pre-package body 140, which is shown transparent.

Figure 11A illustrates the use of the pre-package 1000 as an inlay in a SSO8 standard semiconductor package 1110. The pre-package 1000 is flipped, the encapsulant 190 of the semiconductor package 1100 is shown semi-transparent. The semiconductor package 1100 includes a drain terminal 180_1 (e.g., formed as a plate or paddle) and a source terminal 180_2 (e.g. formed as a plate or paddle). The footprint of the semiconductor package 1100 may be identical to the footprint of the SSO8 standard semiconductor package, though the integration of the pre-package 1000 in the semiconductor package 1100 is different from standard chip integration in SSO8 packages, since no clip is used and the pre-package 1000 is implemented in a flipped orientation in the semiconductor package 1100.

Figure 11B illustrates a top view of the semiconductor package 1100, showing the encapsulant 190 of the semiconductor package 1100 in which the pre-package 1000 is embedded.

In all examples disclosed herein, the transistor chip 120 may be, e.g., capable of switching high currents and/or medium voltages or high voltages. In particular, exemplary transistor packages 100, 200, 300, 700, 1100 as disclosed herein may operate in the medium voltage (MV) range, in which the blocking voltage is equal to or greater than or less than 200 V or 150 V or 100 V or 50 V. Power transistor chips 120 operating in the MV range can be manufactured with a very low R_{DS(on)}, resulting in that the package interconnect resistance adds significantly to the overall package R_{DS(on)}. The pre-package concept disclosed herein makes it possible to preserve the very low R_{DS(on)} of the power transistor chip 120 and at the same time offers a cost-effective and space-saving technology for integrating the power transistor chip 120 into a package, in particular a standard package.

### EXAMPLES

The following examples pertain to further aspects of the disclosure:
Example 1 is a power transistor chip package including a pre-package, a pre-package carrier on which the pre-package is mounted and an encapsulant embedding the pre-package and the pre-package carrier. The pre-package includes a power transistor chip having a first side and a second side opposite the first side. The power transistor chip is a lateral semiconductor device. A plurality of source load pads and a plurality of drain load pads are arranged at the first side of the power transistor chip. A pre-package body embeds the power transistor chip at least at its first side, the pre-package body comprising a first side facing away from the first side of the power transistor chip. A structured metal layer is disposed over the first side of the pre-package body. The structured metal layer comprises one continuous source load structure and one continuous drain load structure. A pre-package vertical interconnect runs through material of the pre-package body and is configured to connect at least some of the source load pads to the source load structure and at least some of the drain load pads to the drain load structure. The pre-package is mounted on the pre-package carrier with the structured metal layer facing the pre-package carrier.

In Example 2, the subject matter of Example 1 can optionally include wherein the pre-package carrier is a leadframe.

In Example 3, the subject matter of Example 1 or 2 can optionally include wherein the semiconductor package is a standard Joint Electron Device Engineering Council, JEDEC, package, in particular a TOLx package with x = T, L, or G, or a SSO8 package.

In Example 4, the subject matter of any of the preceding Examples can optionally include wherein the power transistor chip is a GaN transistor chip.

In Example 5, the subject matter of any of the preceding Examples can optionally include wherein the pre-package body is a laminated body.

In Example 6, the subject matter of any of claims 1 to 4, wherein the pre-package body is a mold compound body.

In Example 7, the subject matter of any of the preceding Examples can optionally include wherein the structured metal layer is a plated metal layer having a thickness between 25 µm and 105 µm or 35 µm and 70 µm.

In Example 8, the subject matter of any of the preceding Examples can optionally include wherein the plurality of source load pads and the plurality of drain load pads are arranged in an interdigitated load pad array.

In Example 9, the subject matter of any of the preceding Examples can optionally include wherein the pre-package vertical interconnect comprises a plurality of vertical source interconnect structures running through material of the pre-package body and configured to connect at least some of the source load pads to the source load structure; and a plurality of vertical drain interconnect structures running through material of the pre-package body and configured to connect at least some of the drain load pads to the drain load structure.

In Example 10, the subject matter of any of the preceding Examples can optionally include wherein the encapsulant is a mold encapsulant.

Example 11 is pre-package, comprising: a power transistor chip having a first side and a second side opposite the first side, the power transistor chip being a lateral semiconductor device; a plurality of source load pads and a plurality of drain load arranged at the first side of the power transistor chip; a pre-package body embedding the power transistor chip at least at its first side, the pre-package body comprising a first side facing away from the first side of the power transistor chip; a structured metal layer disposed over the first side of the pre-package body, the structured metal layer comprising one continuous source load structure and one continuous drain load structure; and a pre-package vertical interconnect running through material of the pre-package body and configured to connect at least some of the source load pads to the source load structure and at least some of the drain load pads to the drain load structure.

In Example 12, the subject matter of Example 11 can optionally include wherein the plurality of source load pads and the plurality of drain load pads are arranged in an interdigitated load pad array.

In Example 13, the subject matter of Example 11 or 12 can optionally further include a metal layer disposed over the second side of the power transistor chip.

In Example 14, the subject matter of Example 13 can optionally further include wherein the pre-package body embeds the power transistor chip at its second side, the pre-package body comprises a second side facing away from the second side of the power transistor chip and the metal layer is disposed over the second side of the pre-package body.

In Example 15, the subject matter of Example 14 can optionally further include wherein the metal layer is coupled to the second side of the power transistor chip by an array of vertical interconnect structures.

In Example 16, the subject matter of any of Examples 13 to 15 can optionally include wherein the metal layer is a plated metal layer having a thickness between 25 µm and 105 µm or 35 µm and 70 µm.

In Example 17, the subject matter of any of Examples 13 to 16 can optionally include wherein the structured metal layer is the sole off-chip metal layer of the pre-package in a direction facing away from the first side of the power transistor chip.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor package, comprising:
a pre-package;
a pre-package carrier on which the pre-package is mounted; and
an encapsulant embedding the pre-package and the pre-package carrier, wherein the pre-package comprises
a power transistor chip having a first side and a second side opposite the first side, the power transistor chip being a lateral semiconductor device;
a plurality of source load pads and a plurality of drain load pads arranged at the first side of the power transistor chip;
a pre-package body embedding the power transistor chip at least at its first side, the pre-package body comprising a first side facing away from the first side of the power transistor chip;
a structured metal layer disposed over the first side of the pre-package body, the structured metal layer comprises one continuous source load structure and one continuous drain load structure; and
a pre-package vertical interconnect running through material of the pre-package body and configured to connect at least some of the source load pads to the source load structure and at least some of the drain load pads to the drain load structure; wherein
the pre-package is mounted on the pre-package carrier with the structured metal layer facing the pre-package carrier.

2. The semiconductor package of claim 1, wherein the pre-package carrier is a leadframe.

3. The semiconductor package of claim 1 or 2, wherein the semiconductor package is a standard Joint Electron Device Engineering Council, JEDEC, package, in particular a TOLx package with x = T, L, or G, or a SSO8 package.

4. The semiconductor package of any of the preceding claims, wherein the power transistor chip is a GaN transistor chip.

5. The semiconductor package of any of the preceding claims, wherein the pre-package body is a laminated body.

6. The semiconductor package of any of claims 1 to 4, wherein the pre-package body is a mold compound body.

7. The semiconductor package of any of the preceding claims, wherein the structured metal layer is a plated metal layer having a thickness between 25 µm and 105 µm or 35 µm and 70 µm.

8. The semiconductor package of any of the preceding claims, wherein the plurality of source load pads and the plurality of drain load pads are arranged in an interdigitated load pad array.

9. The semiconductor package of any of the preceding claims, wherein the pre-package vertical interconnect comprises:
a plurality of vertical source interconnect structures running through material of the pre-package body and configured to connect at least some of the source load pads to the source load structure; and
a plurality of vertical drain interconnect structures running through material of the pre-package body and configured to connect at least some of the drain load pads to the drain load structure.

10. The semiconductor package of any of the preceding claims, wherein the encapsulant is a mold encapsulant.

11. A pre-package, comprising:
a power transistor chip having a first side and a second side opposite the first side, the power transistor chip being a lateral semiconductor device;
a plurality of source load pads and a plurality of drain load arranged at the first side of the power transistor chip;
a pre-package body embedding the power transistor chip at least at its first side, the pre-package body comprising a first side facing away from the first side of the power transistor chip;
a structured metal layer disposed over the first side of the pre-package body, the structured metal layer comprising one continuous source load structure and one continuous drain load structure; and
a pre-package vertical interconnect running through material of the pre-package body and configured to connect at least some of the source load pads to the source load structure and at least some of the drain load pads to the drain load structure.

12. The pre-package of claim 11, wherein the plurality of source load pads and the plurality of drain load pads are arranged in an interdigitated load pad array.

13. The pre-package of claim 11 or 12, further comprising:
a metal layer disposed over the second side of the power transistor chip.

14. The pre-package of claim 13, wherein the pre-package body embeds the power transistor chip at its second side, the pre-package body comprises a second side facing away from the second side of the power transistor chip and the metal layer is disposed over the second side of the pre-package body.

15. The pre-package of claim 14, wherein the metal layer is coupled to the second side of the power transistor chip by an array of vertical interconnect structures.

16. The pre-package of any of claims 13 to 15, wherein the metal layer is a plated metal layer having a thickness between 25 µm and 105 µm or 35 µm and 70 µm.

17. The pre-package of any of claims 13 to 16, wherein the structured metal layer is the sole off-chip metal layer of the pre-package in a direction facing away from the first side of the power transistor chip.
